# FASCICULE DE BREVET EUROPEEN

(11) **EP 2 897 162 B1**
(45) Date de publication et mention de la délivrance du brevet: **17.08.2016**
(21) Numéro de dépôt: 14195216.8
(22) Date de dépôt: 27.11.2014
(51) Int. Cl.: H01L 23/26, H01L 23/10, H01L 23/31, B81B 7/00, B81C 1/00

(54) **Structure d'encapsulation comprenant des tranchees partiellement remplies de materiau getter**
Einkapselungsstruktur, die teilweise mit Gettermaterial gefüllte Rinnen umfasst
Encapsulation structure including trenches partially filled with getter material

(30) Priorité: 29.11.2013 FR 1361827
(43) Date de publication de la demande: 22.07.2015
(73) Titulaire: Commissariat à l'Énergie Atomique et aux Énergies Alternatives, 75015 Paris (FR)
(72) Inventeur: Baillin, Xavier, 38920 CROLLES (FR)
(74) Mandataire: Brevalex

(56) Documents cités:
- EP-A1- 2 450 949
- EP-A2- 1 585 371
- DE-A1-102008 060 796
- FR-A1- 2 981 059
- FR-A1- 2 981 198
- US-A1- 2002 070 421
- US-B1- 6 252 294
- US-B1- 7 160 368

## Description

### DOMAINE TECHNIQUE

L'invention concerne une structure d'encapsulation comprenant une cavité fermée hermétiquement dans laquelle sont encapsulés au moins un micro-dispositif, également appelé microsystème ou microcomposant, par exemple de type MEMS (microsystème électromécanique), NEMS (nano-système électromécanique), MOEMS (microsystème opto-électro-mécanique), NOEMS (nano-système opto-électro-mécanique), ou de type micro-détecteur infrarouge, ou plus généralement tout dispositif destiné à être encapsulé sous atmosphère contrôlée, éventuellement avec un ou plusieurs composants électroniques, formant par exemple un circuit intégré, et un matériau getter.

L'invention concerne également un procédé d'encapsulation d'au moins un micro-dispositif permettant de réaliser une telle structure d'encapsulation.

### ART ANTÉRIEUR

Certains micro-dispositifs, tels que ceux de type MEMS, NEMS, MOEMS ou des micro-détecteurs infrarouges, nécessitent pour leur bon fonctionnement d'être enfermés, ou encapsulés, de manière hermétique dans une cavité dont l'atmosphère est contrôlée (contrôle de la nature du ou des gaz et de la pression dans la cavité).

Une telle encapsulation peut être réalisée de manière collective pour plusieurs micro-dispositifs réalisés sur un même substrat (ou wafer), appelé premier substrat. Chacun des micro-dispositifs est alors encapsulé dans une cavité formée par report et scellement hermétique d'un capot, par exemple formé par un deuxième substrat de silicium ou de verre, sur le premier substrat. Cet assemblage hermétique entre le premier substrat et le deuxième substrat, appelé « wafer-to-wafer » (W2W) et formant de manière collective les cavités d'encapsulation des micro-dispositifs, permet de protéger l'atmosphère régnant dans les cavités en empêchant les fuites de gaz entre l'intérieur des cavités et l'environnement extérieur. En variante, les cavités peuvent être formées par une encapsulation de type TFP (« Thin Film Packaging »), ou PCM (Packaging Couche Mince), les capots étant dans ce cas formés d'une ou plusieurs couches minces superposées et réalisées sur le premier substrat via l'utilisation d'un matériau sacrificiel sur lequel la ou les couches minces sont déposées.

L'ajout de getters non évaporables (NEG) dans les cavités, par exemple sous la forme de portions solides de matériau getter disposées dans ces cavités, permet de contrôler les caractéristiques de l'atmosphère au sein des cavités via un pompage gazeux réalisé par ces getters. Les portions de matériau getter peuvent être réalisées à partir d'un dépôt en couche mince du matériau getter effectué sur l'un ou l'autre des deux substrats, préalablement à l'opération d'assemblage W2W entre les deux substrats, ou à partir d'un dépôt sur le premier substrat dans le cas d'une encapsulation de type TFP. Une mise en forme des portions de matériau getter dans le plan de la surface du substrat sur laquelle le matériau getter est déposé est ensuite réalisée en mettant en oeuvre des opérations technologiques de photolithographie et de gravure de la couche mince de matériau getter. Dans le cas d'une encapsulation de type TFP, le matériau getter peut être réalisé sous la forme d'une couche mince correspondant à la première couche de l'empilement de couches minces du capot, formant ainsi la paroi intérieure du capot délimitant la cavité.

En variante, il est possible de déposer le matériau getter de manière discrète, directement sous la forme souhaitée. Pour cela, le matériau getter peut être déposé directement sur l'un ou l'autre des deux substrats soit à travers un pochoir, soit par lift-off à travers un film de résine photosensible préalablement mis en forme par photolithographie, ce film de résine étant retiré après le dépôt du matériau getter à travers celui-ci.

En général, lors d'un assemblage de type W2W, le getter déposé est monolithique, de forme carrée ou rectangulaire et seule la face opposée à celle en contact avec le substrat sur lequel le getter est déposé est au contact de l'atmosphère de la cavité. Le getter peut être déposé sur le substrat qui accueille le dispositif, c'est-à-dire le premier substrat, ou sur le deuxième substrat servant de capot. Dans le cas d'une encapsulation de type TFP, le getter peut être déposé soit d'une façon identique au cas précèdent, c'est-à-dire sur le premier substrat, soit sur la couche sacrificielle qui permet de construire le capot en couches minces. Dans tous les cas, seule la face opposée à celle en contact avec le substrat d'accueil ou les couches minces du capot est apte à réaliser une absorption et/ou une adsorption gazeuse. De plus, dans une telle configuration, la surface nécessaire à la réalisation de la portion de matériau getter est importante.

Le document US 5 921 461 décrit une structure d'encapsulation dans laquelle des capteurs lumineux sont encapsulés dans une cavité définie entre une base et un capot assemblés l'un à l'autre après le dépôt du getter. Le getter est déposé sur la base, dans une zone ne comprenant pas les capteurs et ne se trouvant pas en regard de fenêtres transparentes formées dans le capot. Le getter peut notamment être réalisé sous la forme d'une grille, ce qui permet de réaliser les capteurs entre les portions de matériau getter formant la grille. Bien qu'une telle configuration permet de positionner précisément les portions de matériau getter sur la base sans perturber le fonctionnement des capteurs, et réduire ainsi les contraintes liées à la surface nécessaire à la réalisation du matériau getter par rapport à une portion de matériau getter monolithique, la surface de matériau getter ainsi obtenue peut dans certains cas s'avérée insuffisante, comme par exemple pour atteindre un vide poussé de l'ordre de 10⁻⁴ à 10⁻³ mbar au sein de la cavité.

Afin d'augmenter la surface de matériau getter exposée dans la cavité, le document FR 2 976 933 décrit une structure d'encapsulation comprenant un matériau getter déposé sur un matériau perméable au gaz. Ainsi, la face du matériau getter en contact avec le matériau perméable aux gaz est accessible et apte à réaliser une adsorption et/ou une absorption gazeuse, en plus des autres faces du matériau getter. Bien qu'une telle structure permet d'obtenir une capacité de pompage gazeux accrue pour une portion de matériau getter donnée, cette structure n'est pas adaptée lorsque la surface disponible pour la réalisation du getter est réduite et/ou irrégulière étant donné la structure monolithique de la portion de matériau getter réalisée. Les documents FR 2 981 059 A1 et US 6 252 294 B1 divulguent également des encapsulations utilisant des matériaux getter.

### EXPOSÉ DE L'INVENTION

Un but de la présente invention est de proposer une structure d'encapsulation permettant d'avoir à la fois une importante surface de matériau getter exposée dans la cavité de la structure d'encapsulation tout en ne nécessitant qu'une surface d'occupation réduite dans la cavité pour la réalisation du matériau getter et/ou qui soit compatible avec une surface d'accueil irrégulière.

Pour cela, il est proposé une structure d'encapsulation comportant au moins :
- une cavité fermée hermétiquement dans laquelle un micro-dispositif est encapsulé,
- un substrat dont une face délimite un côté de la cavité,
- une ou plusieurs tranchées formées à travers ladite face du substrat,
- des premières portions de matériau getter recouvrant au moins en partie des parois latérales de la ou des tranchées.

Il est proposé en outre une structure d'encapsulation comportant au moins :
- une cavité fermée hermétiquement dans laquelle un micro-dispositif est encapsulé,
- un substrat dont une face délimite un côté de la cavité,
- au moins deux tranchées formées à travers ladite face du substrat, des volumes intérieurs de chacune des tranchées communiquant entre eux,
- des premières portions de matériau getter recouvrant au moins en partie des parois latérales des tranchées.

La réalisation des portions de matériau getter au sein de tranchées formées dans le substrat (ce substrat pouvant correspondre à un premier substrat sur lequel le micro-dispositif est réalisé et/ou à un deuxième substrat formant le capot de la cavité dans le cas d'un assemblage W2W entre le premier substrat et le deuxième substrat) permet ainsi de répondre au besoin d'un getter présentant un encombrement réduit en ce qui concerne la surface d'occupation sur le substrat grâce à l'utilisation des surfaces des parois latérales des tranchées sur lesquelles sont disposées les portions de matériau getter. Ainsi, pour une surface donnée du substrat correspondant à la surface occupée par les tranchées, la surface des premières portions de matériau getter disposées sur les parois latérales de ces tranchées peut être supérieure à la surface du substrat occupée par ces tranchées. En outre, pour une surface donnée d'occupation sur le substrat, la capacité de pompage du matériau getter obtenue avec une telle structure d'encapsulation peut être supérieure à celle qui serait obtenue avec une portion de matériau getter déposée directement sur cette surface d'occupation sans tranchée.

La réalisation des premières portions de matériau getter au moins sur les parois latérales des tranchées permet en outre de réaliser ces premières portions de matériau getter sur des surfaces d'accueil irrégulières car ces premières portions de matériau getter ne nécessitent pas d'avoir, au niveau du substrat, une surface importante, plane et régulière. En effet, le fait que les tranchées soient réparties de manière régulière ou non dans le substrat n'affecte pas la capacité de pompage gazeux des portions de matériau getter formées sur les parois latérales de ces tranchées.

L'utilisation des parois latérales des tranchées pour y disposer des portions de matériau getter permet de localiser judicieusement le matériau getter dans des zones qui peuvent être étroites et de façon à ne pas perturber le fonctionnement du ou des micro-dispositifs encapsulés.

De plus, avec une telle structure d'encapsulation, hormis les tranchées, il n'est pas nécessaire de structurer le substrat au niveau duquel les portions de matériau getter sont réalisées, ce qui facilite la mise en oeuvre des opérations technologiques ultérieures sur ce substrat.

La géométrie des tranchées réalisées est également aisément ajustable en fonction des besoins d'absorption et/ou d'adsorption gazeuse dans la structure d'encapsulation, et donc en fonction de la surface de dépôt nécessaire aux portions de matériau getter pour réaliser cette absorption et/ou cette adsorption gazeuse.

Enfin, une telle structure d'encapsulation est compatible avec un assemblage de type W2W, c'est-à-dire via l'assemblage de deux substrats entre eux, ou avec une encapsulation de type TFP.

La structure d'encapsulation permet en outre d'atteindre un vide poussé de l'ordre de 10⁻⁴ à 10⁻³ mbar au sein de la cavité.

Du fait que les volumes intérieurs de chacune des tranchées communiquent entre eux, il est possible d'avoir accès à ces volumes intérieurs via par exemple une seule ouverture formant un accès direct au volume intérieur d'une des tranchées.

L'invention propose une structure d'encapsulation comportant au moins :
- une cavité fermée hermétiquement dans laquelle un micro-dispositif est encapsulé,
- un substrat dont une face délimite un côté de la cavité,
- au moins deux tranchées formées à travers ladite face du substrat, des volumes intérieurs de chacune des tranchées communiquant entre eux,
- des premières portions de matériau getter recouvrant au moins en partie des parois latérales des tranchées sans remplir entièrement les tranchées, et recouvrant complètement les tranchées au niveau de ladite face du substrat,
- une ouverture réalisée à travers l'une des premières portions de matériau getter ou à travers le substrat et faisant communiquer les volumes intérieurs des tranchées avec un volume intérieur de la cavité.

Les première portions de matériau getter ne remplissent que partiellement les tranchées, une partie du volume des tranchées n'étant pas occupée par le matériau getter.

Les tranchées peuvent être réalisées dans le substrat selon un motif de grille tel que chacune des tranchées croise au moins une autre tranchée.

La structure d'encapsulation peut comporter en outre une ou plusieurs deuxièmes portions de matériau getter disposées au niveau d'une ou plusieurs parois de fond des tranchées. Cette configuration permet de mettre à profit également la ou les parois de fond d'une ou plusieurs des tranchées, et donc d'avoir, pour une même surface d'occupation sur le substrat, une plus grande surface de matériau getter permettant de réaliser une absorption et/ou une adsorption de gaz.

Les matériaux getter des premières et/ou deuxièmes portions de matériau getter peuvent être choisis par exemple parmi du zirconium et/ou du titane et/ou tout autre matériau métallique présentant des propriétés d'absorption et/ou d'adsorption gazeuse et/ou par une combinaison de ces matériaux.

Les premières portions de matériau getter peuvent recouvrir partiellement au moins l'une des tranchées au niveau de ladite face du substrat. Ainsi, les surfaces des premières portions de matériau getter, et éventuellement les surfaces d'une ou plusieurs deuxièmes portions de matériau getter lorsque de telles deuxièmes portions de matériau getter sont formées au niveau de parois de fond d'une ou plusieurs des tranchées, permettant de réaliser un pompage de gaz peuvent être directement accessibles depuis un ou plusieurs espaces libres situés entre les premières portions de matériau getter disposées sur les parois latérales d'une tranchée.

En variante, les premières portions de matériau getter peuvent recouvrir complètement les tranchées au niveau de ladite face du substrat, et au moins une ouverture peut être réalisée à travers l'une des premières portions de matériau getter ou à travers le substrat et faire communiquer les volumes intérieurs des tranchées avec un volume intérieur de la cavité. Dans ce cas, les surfaces des premières portions de matériau getter permettant de réaliser un pompage de gaz peuvent être accessibles depuis cette ouverture. De plus, du fait que les volumes intérieurs de chacune des tranchées communiquent entre eux, une seule ouverture peut par exemple permettre à mettre en contact les premières portions de matériau getter avec l'atmosphère régnant dans la cavité via cette ouverture.

Dans ce cas, l'ouverture peut être bouchée par un matériau de bouchage. Un tel matériau de bouchage, correspondant par exemple à un matériau fusible, peut servir à mettre en communication les volumes intérieurs des tranchées avec l'atmosphère de la cavité ultérieurement à l'encapsulation du micro-dispositif, en libérant l'ouverture de ce matériau de bouchage (par exemple en faisant fondre le matériau fusible) ultérieurement à l'encapsulation. Cela peut permettre par exemple de libérer un volume de vide (ou une pression particulière) ou de gaz particulier stocké dans les volumes intérieurs des tranchées à une moment souhaité, par exemple pour rétablir un certain niveau de vide ou une pression de gaz particulière au cours de la durée de vie du micro-dispositif, ou encore d'activer la fonction de pompage des portions de matériau getter au moment souhaité, ultérieurement à la réalisation de la structure d'encapsulation. Il est notamment possible de libérer un gaz rare tel que de l'argon ou du krypton stocké dans les volumes intérieurs des tranchées. Dans ce cas, le matériau getter peut servir à pomper les gaz autres que les gaz rares présents dans la cavité, pour aboutir à une atmosphère de gaz rare contrôlée. Une telle configuration est avantageuse lorsqu'un micro-dispositif résonant fonctionnant sous une pression partielle de gaz est encapsulé dans la cavité.

Les premières portions de matériau getter peuvent recouvrir des parties de ladite face du substrat se trouvant autour des tranchées. On peut ainsi utiliser les parties de la surface du substrat pour augmenter la surface de matériau getter exposée à l'atmosphère de la cavité.

Les premières portions de matériau getter peuvent comporter des grains colonnaires orientés selon une direction formant un angle non nul et inférieur à 90° avec les parois latérales des tranchées. Une telle disposition des grains colonnaires du matériau getter des premières portions permet d'accroitre la capacité d'absorption et/ou d'adsorption gazeuse des premières portions de matériau getter.

Des dimensions d'au moins une des tranchées, au niveau de ladite face du substrat, peuvent être inférieures à des dimensions de ladite au moins une des tranchées au niveau d'une paroi de fond de ladite au moins une des tranchées. Une telle configuration peut avantageusement être utilisée lorsqu'au moins une des tranchées sert en outre de réserve de vide ou de gaz destinée à être libérée ultérieurement à la réalisation de la structure d'encapsulation car avec de telles dimensions, un plus grand volume de vide ou de gaz peut être stocké dans cette ou ces tranchées. La section de ladite au moins une des tranchées, dans un plan perpendiculaire à ladite face du substrat, peut être de type trapézoïdale.

Au moins une partie d'au moins une des tranchées peut comporter plusieurs tranchées secondaires formées à travers ladite face du substrat, disposées les unes à côté des autres et dont les volumes intérieurs communiquent entre eux, les premières portions de matériau getter pouvant recouvrir au moins en partie des parois latérales des tranchées secondaires. De telles tranchées secondaires peuvent par exemple servir à accroitre la surface de matériau getter réalisée en utilisant au mieux les surfaces libres du substrat, ces tranchées secondaires étant par exemple réalisées au niveau de régions du substrat présentant une surface libre plus importante que celle des autres régions du substrat où est réalisé le reste de la ou des tranchées ne comportant pas de tranchées secondaires.

Les premières portions de matériau getter peuvent être formées par au moins une première couche d'un premier matériau getter et au moins une deuxième couche d'un deuxième matériau getter.

Le deuxième matériau getter peut être différent du premier matériau getter. Ainsi, il est possible d'obtenir différentes propriétés d'absorption et/ou d'adsorption gazeuse dans la cavité (vis-à-vis de la nature des gaz à piéger et/ou de la température d'activation thermique par exemple).

La première couche du premier matériau getter peut recouvrir complètement les tranchées au niveau de ladite face du substrat, et la deuxième couche du deuxième matériau getter peut recouvrir la première couche du premier matériau getter.

En variante, la première couche du premier matériau getter peut recouvrir partiellement les tranchées au niveau de ladite face du substrat, et la deuxième couche du deuxième matériau getter peut recouvrir la première couche du premier matériau getter et fermer complètement les tranchées au niveau de ladite face du substrat.

Il est également proposé un procédé d'encapsulation d'au moins un micro-dispositif, comportant au moins la mise en oeuvre des étapes de :
- réalisation d'au moins deux tranchées à travers une face d'un substrat telles que des volumes intérieurs de chacune des tranchées communiquent entre eux;
- réalisation de premières portions de matériau getter recouvrant au moins en partie des parois latérales des tranchées ;
- fermeture hermétique d'une cavité dans laquelle le micro-dispositif est disposé et telle que ladite face du substrat délimite un côté de la cavité.

Un tel procédé d'encapsulation peut avantageusement être mis en oeuvre pour réaliser une encapsulation collective de plusieurs micro-dispositifs dans différentes cavités pour réaliser un packaging de ces micro-dispositifs sous atmosphère contrôlée.

L'invention porte également sur un procédé d'encapsulation d'au moins un micro-dispositif, comportant au moins la mise en oeuvre des étapes de :
- réalisation d'au moins deux tranchées à travers une face d'un substrat telles que des volumes intérieurs de chacune des tranchées communiquent entre eux;
- réalisation de premières portions de matériau getter recouvrant au moins en partie des parois latérales des tranchées sans remplir entièrement les tranchées, et recouvrant complètement les tranchées au niveau de ladite face du substrat ;
- réalisation d'au moins une ouverture à travers l'une des premières portions de matériau getter ou à travers le substrat et faisant communiquer les volumes intérieurs des tranchées avec un volume intérieur d'une cavité dans laquelle le micro-dispositif est disposé et telle que ladite face du substrat délimite un côté de la cavité ;
- fermeture hermétique de la cavité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent schématiquement des structures d'encapsulation, objets de la présente invention, selon différents modes de réalisation ;
- les figures 4 à 18 représentent schématiquement des exemples de réalisation de tranchées de structures d'encapsulation, objets de la présente invention, dans lesquelles des portions de matériau getter sont réalisées.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

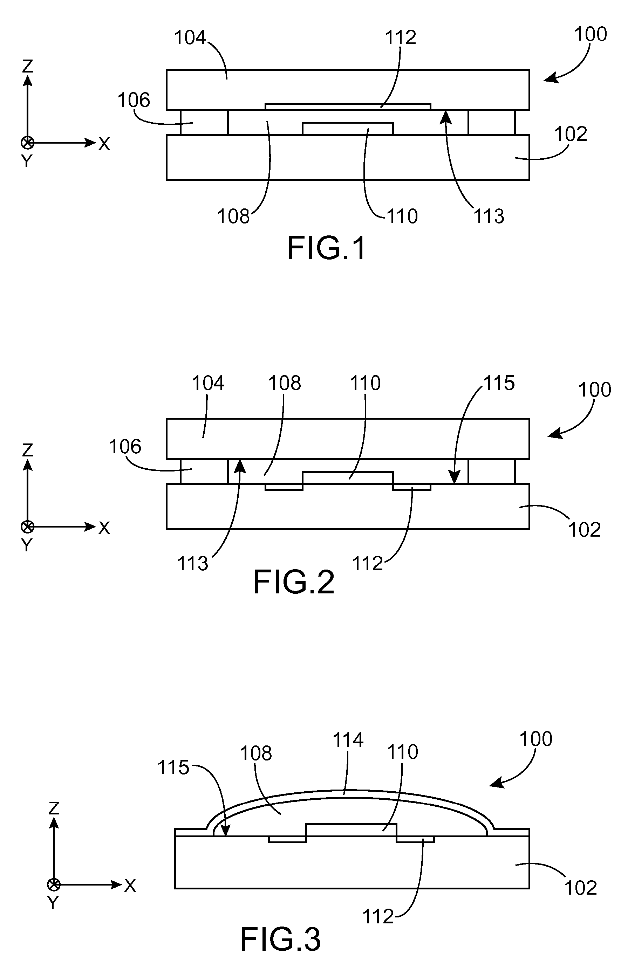

On se réfère tout d'abord à la figure 1 qui représente schématiquement une structure d'encapsulation 100 selon un premier mode de réalisation.

Cette structure d'encapsulation 100 est de type W2W, c'est-à-dire est formée par l'assemblage d'un premier substrat 102 avec un deuxième substrat 104 formant le capot de la structure d'encapsulation 100, par exemple tous les deux à base d'un semi-conducteur tel que du silicium, ces deux substrats 102 et 104 étant assemblés l'un à l'autre via un cordon de scellement 106. Une cavité 108 est formée par l'espace obtenu entre le premier substrat 102 et le deuxième substrat 104, le cordon de scellement 106 formant les parois latérales de la cavité 108. Un micro-dispositif 110, par exemple de type MEMS, NEMS, MOEMS, NOEMS ou détecteur infrarouge tel qu'un micro-bolomètre, est encapsulé dans la cavité 108. De plus, un matériau getter 112, par exemple du zirconium et/ou du titane ou tout autre matériau métallique présentant des propriétés d'absorption et/ou d'adsorption gazeuse, est également présent dans la cavité 108, au niveau d'une paroi du capot formée par une face 113 du deuxième substrat 104, cette face 113 formant une paroi intérieure de la cavité 108.

La figure 2 représente schématiquement la structure d'encapsulation 100 selon une variante du premier mode de réalisation. Dans cette variante de réalisation, le matériau getter 112 est formé non pas sur la face 113 du deuxième substrat 104, mais sur une face 115 du premier substrat 102 au niveau de laquelle se trouve également le micro-dispositif 110 et formant également une paroi intérieure de la cavité 108. Le matériau getter 112 est ici formé en périphérie du micro-dispositif 110.

Selon une autre variante du premier mode de réalisation, la structure d'encapsulation peut comporter du matériau getter à la fois sur la face 113 du deuxième substrat 104 et sur la face 115 du premier substrat 102.

La figure 3 représente schématiquement la structure d'encapsulation 100 selon un deuxième mode de réalisation. Dans ce deuxième mode de réalisation, la structure d'encapsulation 100 n'est pas de type W2W, mais de type TFP, ou PCM, c'est-à-dire comporte un capot 114 formé d'une ou plusieurs couches minces. Comme dans la variante décrite en liaison avec la figure 2, le matériau getter 112 est formé sur la face 115 du premier substrat 102 sur laquelle se trouve également le micro-dispositif 110.

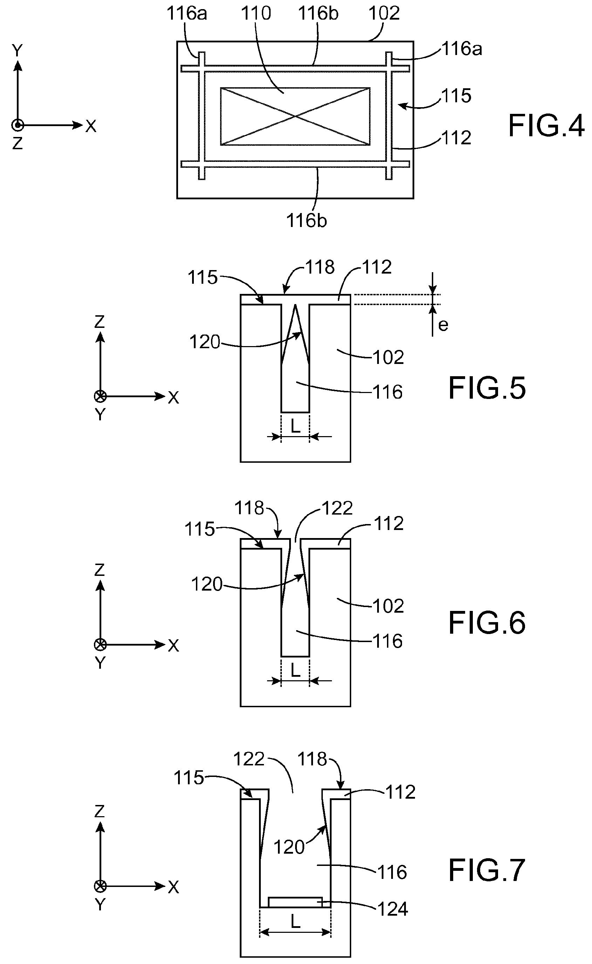

On décrit maintenant, en liaison avec les figures 4 à 18, les détails de réalisation du matériau getter 112 dans la structure d'encapsulation 100. En effet, dans tous les modes ou variantes de réalisation de la structure d'encapsulation 100, le matériau getter 112 est réalisé au moins en partie dans des tranchées, ou canaux, formées à travers la face du substrat au niveau de laquelle se trouve le matériau getter 112, c'est-à-dire à travers la face 113 du deuxième substrat 104 et/ou la face 115 du premier substrat 102. Sur les exemples des figures 4 à 18, les tranchées sont réalisées à travers la face 115 du premier substrat 102, autour du micro-dispositif 110. Les caractéristiques décrites ci-dessous en liaison avec les figures 4 à 18 s'appliquent également lorsque le matériau getter 112 est formé dans des tranchées réalisées à travers la face 113 du deuxième substrat 104.

La figure 4 est une vue de dessus d'une partie du premier substrat 102 de la structure d'encapsulation 100 précédemment décrite en liaison avec la figure 2 ou la figure 3. Le matériau getter est réalisé sous la forme de portions de matériau getter 112 recouvrant au moins en partie (une partie de la hauteur) des parois latérales de tranchées 116 (les portions de matériau getter 112 sont déposées sur des parties supérieures des parois latérales des tranchées 116) réalisées à travers la face 115 du premier substrat 102, dans une partie de l'épaisseur du premier substrat 102. Ces tranchées 116 sont réalisées sous la forme d'un réseau qui correspond ici, dans un plan parallèle à la face 115 du premier substrat 102 (plan (X,Y) sur la figure 4), à un motif de grille. Sur l'exemple de la figure 4, ce motif de grille est formé par des tranchées verticales 116a, parallèles à l'axe Y, croisant perpendiculairement des tranchées horizontales 116b parallèles à l'axe X.

En variante, les tranchées 116 peuvent se croiser en formant un motif différent, par exemple un maillage de forme quelconque, polygonale ou non. Il est également possible de réaliser les tranchées 116 telles qu'elles ne se croisent pas, ou encore réaliser une unique tranchée 116 par exemple formée autour du micro-dispositif 110.

La figure 5 représente une vue de profil d'un premier exemple de réalisation des tranchées 116, correspondant ici à une des tranchées verticales 116a. La dimension selon l'axe X de la tranchée 116 représentée sur la figure 5 correspond à la largeur L de cette tranchée 116. Les portions de matériau getter 112 sont déposées sur une partie des parois latérales de la tranchée 116. Ces parois latérales de la tranchée 116 sont sensiblement perpendiculaires à la face 115 du premier substrat 102. Dans ce premier exemple de réalisation, les portions de matériau getter 112 déposées sur les parois latérales de la tranchée 116 se rejoignent au niveau de la face 115 et recouvrent ainsi complètement la tranchée 116 dans laquelle les portions de matériau getter 112 sont formées. L'intérieur de la tranchée 116 n'est pas accessible depuis les parties de la tranchée 116 qui sont recouvertes complètement par les portions de matériau getter 112. Les portions de matériau getter 112 recouvrent également des parties de la face 115 du premier substrat 102 se trouvant autour de la tranchée 116.

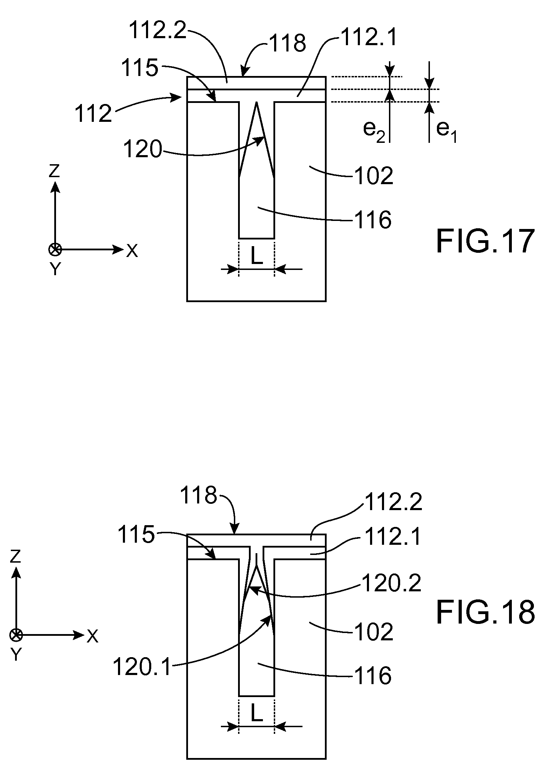

La figure 17 représente une vue de profil d'une variante du premier exemple de réalisation des tranchées 116 précédemment décrit en liaison avec la figure 5. Dans cette variante, les portions de matériau getter 112 sont formées par une première couche 112.1 d'un premier matériau getter d'épaisseur e₁ et une deuxième couche 112.2 d'un deuxième matériau getter d'épaisseur e₂. La première couche 112.1 forme les parties de matériau getter déposées sur les parois latérales de la tranchée 116, ces parties se rejoignant au niveau de la face 115 afin de recouvrir complètement la tranchée 116 au niveau de la face 115 du substrat 102. Les premier et deuxième matériaux getter des couches 112.1 et 112.2 sont avantageusement différents l'un de l'autre. La deuxième couche 112.2 est exposée directement dans la cavité 108 de la structure d'encapsulation 100, tandis que la première couche 112.1 est exposée dans la tranchée 116. Une telle variante permet notamment d'avoir dans la cavité 108 deux matériaux getter ayant des propriétés d'absorption et/ou d'adsorption gazeuse différentes (vis-à-vis de la nature des gaz à piéger et/ou de la température d'activation thermique par exemple). La première couche 112.1 comporte par exemple du titane et la deuxième couche 112.2 comporte par exemple du zirconium (le zirconium ayant une température d'activation thermique inférieure à celle du titane).

La figure 18 représente une vue de profil d'une autre variante du premier exemple de réalisation des tranchées 116 précédemment décrit en liaison avec la figure 5. Dans cette variante, la première couche 112.1 du premier matériau getter ne recouvre que partiellement la tranchée 116 au niveau de la face 115 du substrat 102. La deuxième couche 112.2 du deuxième matériau getter recouvre la première couche 112.1 et ferme complètement la tranchée 116 au niveau de la face 115 du substrat 102. Une telle variante est avantageuse car elle permet de « pré-boucher » la partie haute de la tranchée 116 avec le dépôt du premier matériau getter qui recouvre au moins en partie les parois latérales de la tranchée 116, le deuxième matériau getter permettant de fermer complètement la tranchée 116 et la recouvrir. Cette variante permet d'augmenter la largeur L de la tranchée 116 jusqu'à une valeur égale à environ deux fois l'épaisseur de la deuxième couche 112.2 et donc également d'augmenter la profondeur de la tranchée 116, par exemple jusqu'à une valeur égale à environ soixante fois l'épaisseur de la deuxième couche 112.2 lorsque le rapport de forme de la tranchée est égal à environ 30.

Un dépôt des portions de matériau getter 112 le long des parois latérales des tranchées 116 permet d'obtenir un matériau getter présentant des grains colonnaires orientés selon une direction formant un angle non nul avec les parois latérales des tranchées. Une telle disposition des grains colonnaires du matériau getter permet d'accroitre la capacité d'absorption et/ou d'adsorption gazeuse des premières portions de matériau getter par rapport à un matériau getter déposé de manière classique sous la forme d'une portion monolithique sur le substrat.

L'accès à l'intérieur de la tranchée 116, afin de faire communiquer l'intérieur de la tranchée 116 avec la cavité 108, est obtenu par exemple via au moins une partie d'au moins une des tranchées 116 qui n'est pas recouverte par les portions de matériau getter 112 (non visible sur la figure 4). Cet accès à l'intérieur de la tranchée 116 peut être obtenu dès le dépôt des portions de matériau getter 112 en ne déposant pas le matériau getter sur cette partie d'au moins une des tranchées 116, par exemple via un procédé de type « lift-off » avec un film sec, ou bien postérieurement au dépôt du matériau getter en réalisant une ouverture à travers l'une des portions de matériau getter 112. Du fait que les tranchées 116 réalisées dans le premier substrat 102 se croisent, les volumes intérieurs des tranchées 116 communiquent entre eux. L'accès à l'intérieur d'une des tranchées 116 permet donc de faire communiquer les volumes intérieurs de toutes les tranchées 116 avec l'atmosphère de la cavité 108. L'accès à l'intérieur de la tranchée 116 peut également être obtenu par une ouverture réalisée à travers l'une des portions de matériau getter 112 ou à travers le substrat 102.

Ainsi, dans la structure d'encapsulation 100 comportant de telles tranchées 116 dont les parois latérales sont recouvertes au moins en partie par les portions de matériau getter 112 et dont les volumes intérieurs communiquent avec la cavité 108, une absorption et/ou une adsorption gazeuse est réalisée dans la cavité 108 à la fois par une première surface extérieure 118 des portions de matériau getter 112 qui est directement exposée dans la cavité 108 au niveau de la face 115 du premier substrat 102, mais également par une deuxième surface 120 des portions de matériau getter 112 se trouvant à l'intérieur des tranchées 116, au niveau des parois latérales des tranchées 116 et exposée à l'atmosphère de la cavité 108 via l'accès précédemment décrit, formant ainsi une grande surface de matériau getter exposée à l'atmosphère de la cavité 108 tout en minimisant la surface occupée par le matériau getter au niveau de la face 115 du premier substrat 102. Sur l'exemple de la figure 17, la première surface extérieure 118 correspond à la surface supérieure de la deuxième couche 112.2 et la deuxième surface 120 se trouvant à l'intérieur des tranchées 116 correspond à une surface formée par la première couche 112.1. Sur l'exemple de la figure 18, la première surface extérieure 118 correspond à la surface supérieure de la deuxième couche 112.2. Les couches 112.1 et 112.2 ont chacune une partie de leur surface, respectivement référencée 120.1 et 120.2, exposée dans les tranchées 116.

La figure 6 représente une vue de profil d'un deuxième exemple de réalisation des tranchées 116, correspondant ici à une des tranchées verticales 116a. Dans ce deuxième exemple de réalisation, les portions de matériau getter 112 ne recouvrent pas complètement les tranchées 116 sur lesquelles les portions de matériau getter 112 sont formées. Ainsi, l'intérieur des tranchées 116 est accessible depuis un espace 122 formé entre les portions de matériau getter 112 sur toute la longueur des tranchées 116. Les portions de matériau getter 112 recouvrent également des parties de la face 115 du premier substrat 102 se trouvant autour des tranchées 116. De plus, les portions de matériau getter 112 sont également déposées sur une partie des parois latérales intérieures des tranchées 116, et plus précisément sur les parties supérieures de ces parois latérales. Dans ce deuxième exemple de réalisation, grâce aux espaces 122 formés entre les portions de matériau getter 112, les surfaces 118 et 120 des portions de matériau getter 112 sont directement exposées à l'atmosphère de la cavité 108 sans qu'il soit nécessaire de former ultérieurement une ouverture à travers l'une ou plusieurs des portions de matériau getter 112.

La figure 7 représente une vue de profil d'un troisième exemple de réalisation des tranchées 116, correspondant ici à une des tranchées verticales 116a. Par rapport au deuxième exemple de réalisation précédemment décrit en liaison avec la figure 6, des deuxièmes portions de matériau getter 124 sont disposées au niveau des parois de fond des tranchées 116, ce qui permet d'accroitre encore les surfaces de matériau getter exposées à l'atmosphère de la cavité 108.

Dans les trois exemples de réalisation précédemment décrits en liaison avec les figures 5 à 7 ainsi que dans les variantes des figures 17 et 18, les portions de matériau getter 112 sont réalisées par dépôt au-dessus des tranchées 116. Ainsi, le fait que les portions de matériau getter 112 déposées correspondent à l'un ou l'autre de ces trois exemples de réalisation dépend notamment de la largeur L avec laquelle les tranchées 116 sont réalisées ainsi que de l'épaisseur e des portions de matériau getter 112 déposées. Dans ces trois exemples, la largeur L de la tranchée 116 représentée sur la figure 5 est inférieure à celle de la tranchée 116 représentée sur la figure 6 qui elle-même est inférieure à celle de la tranchée 116 représentée sur la figure 7. Dans le premier exemple représenté sur la figure 5, la largeur L des tranchées 116 est par exemple égale à environ 2 fois l'épaisseur e des portions de matériau getter 112 (ou environ 2 fois l'épaisseur e₁ de la première couche 112.1 dans le cas de la figure 17), cette épaisseur e étant par exemple supérieure ou égale à environ 100 nm, et de préférence comprise entre environ 100 nm et 2 µm. Dans le deuxième exemple représenté sur la figure 6 et le troisième exemple représenté sur la figure 7, la largeur L des tranchées 116 est par exemple supérieure à environ 2 fois l'épaisseur e des portions de matériau getter 112 (ou supérieure à environ 2 fois l'épaisseur de la première couche 112.1 dans le cas de la figure 18). Dans ces trois exemples de réalisation, le rapport de forme des tranchées 116, correspondant au rapport profondeur / largeur des tranchées 116, peut être égal à environ 30 et par exemple compris entre environ 15 et 25.

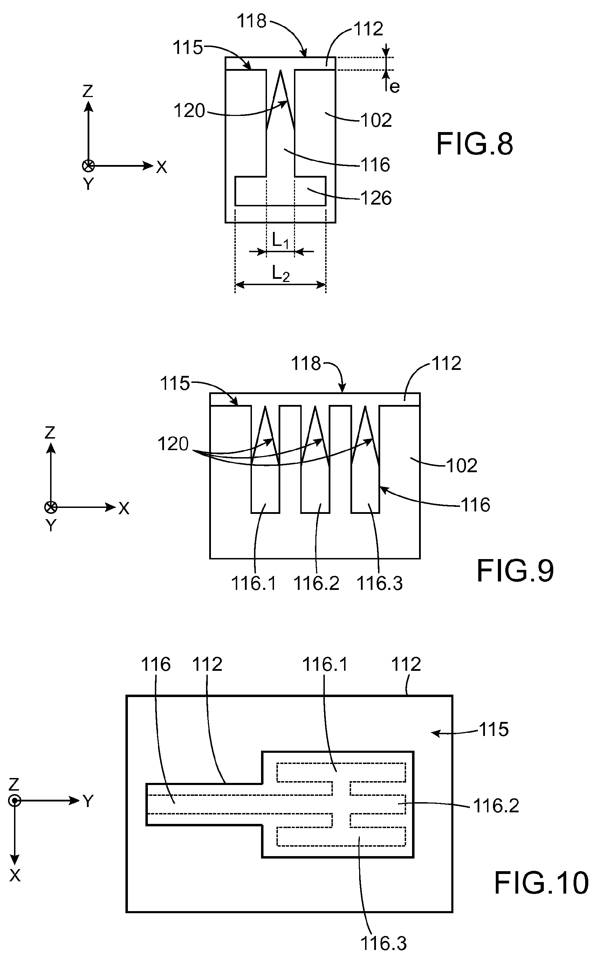

La figure 8 représente une vue de profil d'un quatrième exemple de réalisation d'une tranchée 116, correspondant ici à une des tranchées verticales 116a. Comme pour le premier exemple précédemment décrit en liaison avec la figure 5, l'épaisseur e des portions de matériau getter 112 et la largeur L1 des tranchées 116 sont choisies telles que les portions de matériau getter 112 recouvrent complètement les tranchées 116 sur lesquelles les portions de matériau getter 112 sont formées. Une ou plusieurs des tranchées 116, ou chacune des tranchées 116, comporte une partie inférieure 126 de largeur L2 supérieure à la largeur L1 du reste de la tranchée 116. Les dimensions de la tranchée 116, au niveau de la face 115 du premier substrat 102, sont donc inférieures à des dimensions de la tranchée 116 au niveau d'une paroi de fond de la tranchée 116, c'est-à-dire au niveau de la partie inférieure 126.

Ainsi, si les portions de matériau getter 112 sont déposées sous une atmosphère particulière, par exemple sous vide, et que l'accès aux volumes intérieurs des tranchées 116 n'est réalisé qu'après l'encapsulation hermétique du micro-dispositif 110, via la réalisation d'une ouverture telle que précédemment décrit, les parties inférieures 126 des tranchées 116 forment alors des réserves de cette atmosphère particulière dont les contenus s'ajoutent à l'atmosphère de la cavité 108 après scellement lors de la réalisation de l'ouverture, par exemple des réserves de vide venant s'ajouter ultérieurement au vide avec lequel la cavité 108 est fermée hermétiquement. De telles tranchées 116 sont par exemple réalisées à partir d'un substrat SOI (semi-conducteur sur isolant), les tranchées 116 étant formées tout d'abord à travers toute l'épaisseur de la couche supérieure de semi-conducteur du substrat SOI, les parties inférieures 126 étant ensuite réalisées par gravure de la couche d'isolant enterrée du substrat SOI. De telles tranchées 116, c'est-à-dire comportant des parties inférieures 126 de largeur supérieure au reste des tranchées 116, peuvent également servir pour des dépôts de portions de matériau getter 112 similaires à celles précédemment décrites en liaison avec les figures 6 et 7.

La figure 9 représente une vue de profil d'un cinquième exemple de réalisation des tranchées 116, correspondant ici à une des tranchées verticales 116a. La tranchée 116 est formée de plusieurs tranchées secondaires réalisées sensiblement parallèlement les unes par rapport aux autres. Sur l'exemple de la figure 9, la tranchée 116 est formée de trois tranchées secondaires 116.1 à 116.3 sur lesquelles et dans lesquelles les portions de matériau getter 112 sont déposées (ici comme dans le premier exemple précédemment décrit en liaison avec la figure 5, c'est-à-dire en recouvrant complètement les tranchées secondaires et en recouvrant une partie des parois latérales des tranchées secondaires). Cette subdivision de la tranchée 116 en plusieurs tranchées secondaires peut se faire sur au moins une partie de la longueur de la tranchée 116.

Une telle configuration a notamment pour avantage d'augmenter encore la surface de matériau getter exposée au final dans la cavité 108, tout en augmentant la « réserve » d'atmosphère, en termes de gaz et/ou de pression, que représente le volume intérieures des tranchées 116. Les tranchées secondaires peuvent communiquer entre elles, par exemple en se rejoignant les unes aux autres au niveau d'une partie de la tranchée 116, comme représenté sur la figure 10 qui correspond à une vue de dessus partielle d'une telle tranchée 116. En variante, de telles tranchées secondaires peuvent être réalisées sur toute la longueur d'une ou de plusieurs des tranchées 116, ou sur une partie seulement de la longueur d'une ou plusieurs des tranchées 116 comme c'est le cas sur la figure 10. Il est également possible que les tranchées secondaires ne communiquent pas entre elles. Dans ce cas, chaque tranchée secondaire comporte un accès indépendant permettant de faire communiquer l'intérieur de chacune des tranchées secondaires avec la cavité 108. Ces accès sont avantageusement réalisés à des moments différents, par exemple en fonction des besoins en termes d'absorption / adsorption gazeuse et/ou de réserve d'atmosphère dans la cavité 108. Une telle réalisation des tranchées 116 peut s'appliquer par exemple pour un dépôt de portions de matériau getter 112 similaires à celles précédemment décrites en liaison avec la figure 5. Il est également possible qu'une ou plusieurs des tranchées secondaires comportent une partie inférieure plus large que le reste de la tranchée secondaire, comme précédemment décrit en liaison avec la figure 8.

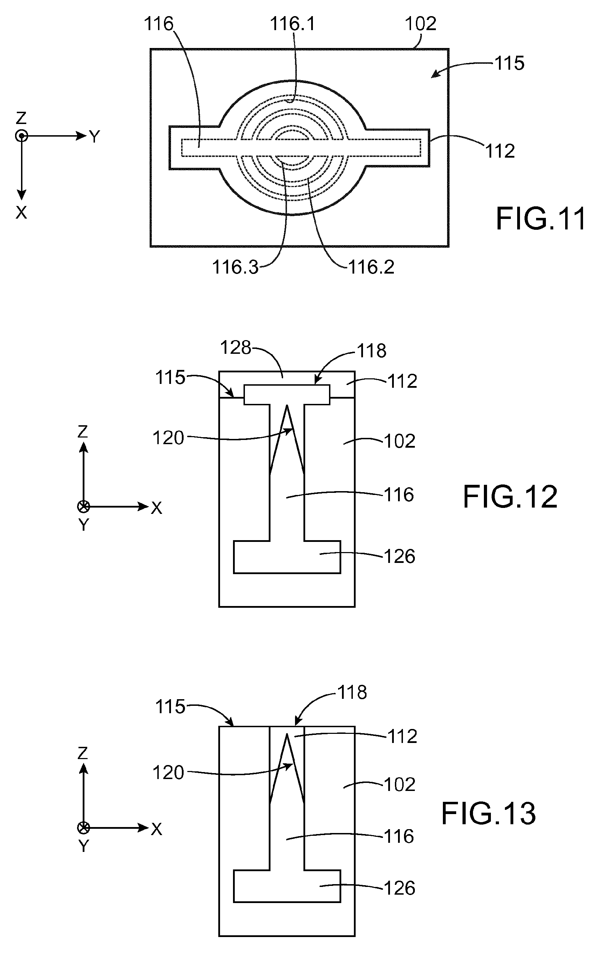

Dans les exemples de réalisation précédemment décrits, les tranchées 116 et/ou les tranchées secondaires sont rectilignes. En variante, les tranchées 116 et/ou les tranchées secondaires peuvent ne pas être rectilignes. La figure 11 est une vue de dessus d'un exemple de réalisation d'une tranchée 116 dont une partie est reliée à trois tranchées secondaires 116.1, 116.2 et 116.3 chacune de forme sensiblement circulaire ou elliptique. Une telle réalisation des tranchées 116 peut s'appliquer pour des dépôts de portions de matériau getter 112 similaires à celles précédemment décrites en liaison avec les figures 5 à 7. Il est également possible qu'une ou plusieurs de ces tranchées secondaires comportent une partie inférieure plus large que le reste de la tranchée secondaire, comme précédemment décrit en liaison avec la figure 8.

Lorsque les portions de matériau getter 112 sont déposées sur la face du substrat autour des tranchées 116 (comme c'est le cas pour l'ensemble des exemples de réalisation précédemment décrits), un aplanissement et/ou une isolation électrique de la face 113 ou 115 du substrat sur laquelle les portions de matériau getter 112 sont déposées peuvent être réalisés en recouvrant les portions de matériau getter 112 et le reste de la face 113 ou 115 du substrat par une couche de passivation 128 adaptée pour réaliser un tel aplanissement et/ou une telle isolation électrique, par exemple à base de SiN ou de SiO₂ déposé avec une épaisseur supérieure à celle des portions de matériau getter 112, par exemple entre environ 1 µm et 10 µm (voir figure 12). Le matériau de la couche de passivation 128 est choisi parmi les matériaux qui sont le moins propice au dégazage après dépôt et lors d'une montée en température de ce matériau. Des couches de distribution (RDL pour « Redistribution Layer ») formant plusieurs niveaux métal - isolant peuvent en outre être réalisées au-dessus de la face 113 ou 115 sur laquelle se trouvent les portions de matériau getter 112, ou au-dessus de la couche de passivation 128. Lorsque les portions de matériau getter 112 sont recouvertes par un autre matériau, la fonction de pompage gazeux est réalisée par les parties des portions de matériau getter 112 se trouvant sur les parois latérales des tranchées 116, depuis les faces 120 des portions de matériau getter 112.

Selon une autre variante, il est possible de réaliser, après le dépôt des portions de matériau getter 112, une planarisation mécano-chimique du matériau getter avec arrêt sur la face 113 ou 115 du substrat. Une telle variante de réalisation est représentée sur la figure 13. La surface plane ainsi obtenue peut servir ensuite à la mise en oeuvre d'autres étapes telles que la réalisation d'une couche de passivation ou de couches de distribution. Une telle planarisation peut s'appliquer pour des dépôts de portions de matériau getter 112 similaires à celles précédemment décrites en liaison avec les figures 6 et 7.

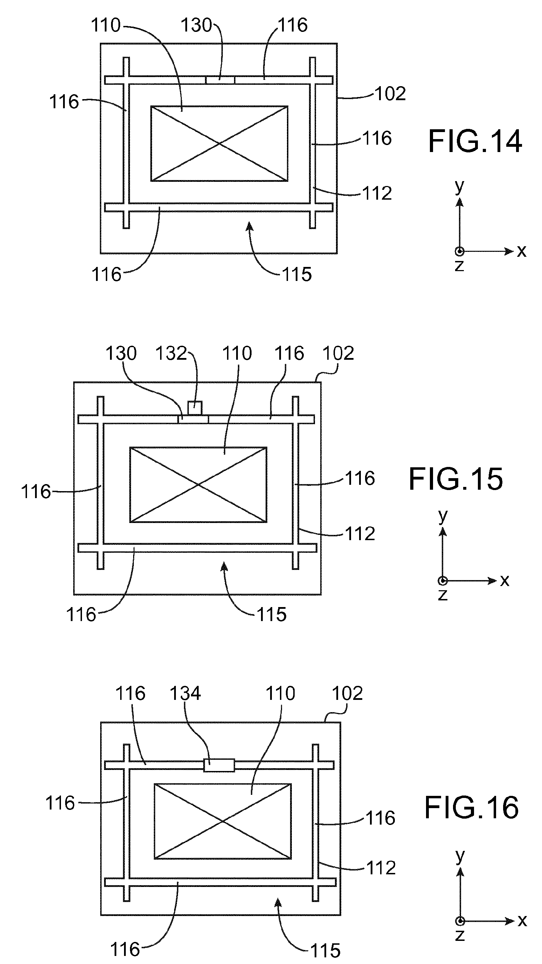

La figure 14 représente une vue de dessus d'une partie du premier substrat 102 de la structure d'encapsulation 100 précédemment décrite en liaison avec la figure 2 ou la figure 3, et dans laquelle les portions de matériau getter 112 recouvrent complètement les tranchées 116. Sur cette figure, une ouverture 130 est réalisée à travers les portions de matériau getter 112 formées sur l'une des tranchées 116, faisant ainsi communiquer l'atmosphère de la cavité 108 avec les volumes intérieurs des tranchées 116, ces volumes intérieurs communiquant entre eux du fait que les tranchées 116 se croisent.

En variante, l'ouverture 130 pourrait être réalisée à travers la face 115 du premier substrat 102. Une telle ouverture pourrait notamment être réalisée lorsque le substrat comportant les tranchées 116 est de type SOI, cette ouverture pouvant faire communiquer l'intérieur des tranchées 116 avec l'atmosphère de la cavité 108 via une gravure d'une partie de la couche diélectrique enterrée permettant ainsi de faire rejoindre l'intérieur d'une des tranchées 116 avec l'ouverture 130 réalisée à travers le substrat. Une telle variante peut être mise en oeuvre en réalisant une gravure sélective du matériau diélectrique enterré par rapport au matériau getter.

Sur l'exemple représenté sur la figure 15, un dépôt localisé d'un matériau de bouchage 132, correspondant par exemple à un matériau fusible tel qu'un métal ou un alliage métallique comprenant par exemple de l'indium et/ou de l'étain et/ou de l'AuSn et/ou de l'AuSi, est réalisé sur la face 115 du premier substrat 102 à proximité de l'ouverture 130. Ainsi, après l'encapsulation du micro-dispositif 110, il est possible de ne plus exposer l'intérieur des tranchées 116 à l'atmosphère de la cavité 108 en faisant fondre ce matériau de bouchage 132 qui, par capillarité, va venir boucher l'ouverture 130. La quantité de matériau de bouchage 132 déposée est choisie telle que ce matériau puisse former un bouchon de taille suffisante pour boucher hermétiquement l'ouverture 130.

La figure 16 représente un autre exemple de réalisation dans lequel l'ouverture 130 est bouchée par un matériau de bouchage 134, correspondant par exemple à un matériau fusible, avant l'encapsulation hermétique du micro-dispositif 110 dans la cavité 108. Ce matériau de bouchage 134 est réalisé tel que la surface de l'ouverture 130 soit légèrement inférieure à la surface du matériau de bouchage 134 déposé. L'épaisseur du matériau de bouchage 134 est de préférence minimisée tout en restant suffisante pour assurer une fermeture hermétique de l'ouverture 130. Après l'encapsulation, il est possible de faire fondre ce matériau de bouchage 134 qui libère alors l'ouverture 130 du fait que le matériau de bouchage 134 va alors s'étaler par mouillage sur le matériau getter, exposant ainsi les volumes intérieurs des tranchées 116 à l'atmosphère de la cavité 108. La nature du matériau de bouchage 134 est choisie notamment en fonction de la température à laquelle l'encapsulation est réalisée, et correspond par exemple à un alliage eutectique tel que de l'AuSi, de l'AuSn, ou de l'AlGe.

Ainsi, les surfaces 120 des portions de matériau getter 112 se trouvant dans les tranchées 116 sont protégées de l'atmosphère ambiante tout au long de la mise en oeuvre du procédé d'encapsulation. De plus, si le dépôt du matériau de bouchage 134 est réalisé sous vide ou sous une atmosphère gazeuse particulière, les volumes intérieurs des tranchées 116 forment alors des réserves de vide ou de cette atmosphère particulière pouvant être libérées à n'importe quel moment après l'encapsulation du micro-dispositif 110 dans la cavité 108, la quantité de ces réserves pouvant être ajustée en fonction des dimensions, et notamment de la profondeur, des tranchées 116.

Après la fermeture hermétique de la cavité 108, les portions de matériau getter 112 sont activées thermiquement en exposant la structure d'encapsulation 100 à une température déclenchant une absorption et/ou une adsorption gazeuse du matériau getter. Cette température d'activation thermique du matériau getter dépend notamment de la nature du matériau getter.

Dans tous les modes et exemples de réalisation précédemment décrits, il est possible de réaliser, entre les portions de matériau getter 112 et le matériau du substrat sur lequel les portions 112 sont réalisées, une sous-couche de matériau permettant d'ajuster la température d'activation thermique du matériau getter. Une telle sous-couche d'ajustement correspond par exemple à une couche de chrome et/ou de platine et/ou d'aluminium, d'épaisseur comprise entre environ 10 nm et 100 nm. La présence d'une telle sous-couche d'ajustement sous les portions de matériau getter 112 permet de modifier la température à laquelle le matériau getter des portions 112 est activé thermiquement, et permet avantageusement d'abaisser cette température d'activation thermique. Une sous-couche d'accroche à base de titane et/ou de chrome et/ou de zirconium, dont l'épaisseur est par exemple comprise entre environ 10 nm et 100 nm, peut être réalisée sous la sous-couche d'ajustement afin d'améliorer l'accroche entre le matériau du premier substrat 102 ou du deuxième substrat 104 et le matériau de la sous-couche d'ajustement. Des détails de réalisation d'une telle sous-couche d'ajustement de la température d'activation thermique du matériau getter et d'une telle sous-couche d'accroche sont décrits dans le document FR 2 922 202.

Dans tous les modes et exemples de réalisation précédemment décrits, il est possible de recouvrir et protéger temporairement les portions de matériau getter 112 par une couche de protection telle qu'une couche de chrome d'épaisseur comprise entre environ quelques nanomètres et 100 nm, ou par une couche de nitrure ou d'oxyde obtenue par voie sèche, comme décrit dans le document FR 2 950 876. Cette couche de protection peut être supprimée lorsque le matériau getter est activé thermiquement.

On décrit maintenant un procédé d'encapsulation du micro-dispositif 110, réalisant la structure d'encapsulation 100.

Les tranchées 116 sont tout d'abord réalisées à travers la face 115 du premier substrat 102 et/ou à travers la face 113 du deuxième substrat 104, ces substrats étant par exemple à base de silicium. Ces tranchées 116 sont par exemple réalisées via la mise en oeuvre d'étapes de photolithographie et gravure de type DRIE (gravure ionique réactive profonde). Un masque dur de SiO₂, par exemple d'épaisseur comprise entre environ 100 nm et 10 µm, permet par exemple de graver des tranchées 116 dont le rapport de forme (profondeur/largeur) est égal à environ 30.

Les portions de matériau getter 112 sont ensuite réalisées sur une partie des flancs latéraux des tranchées 116 et en recouvrant complètement ou partiellement les tranchées 116 au niveau de la face 113 et/ou 115 du substrat dans lequel les tranchées 116 sont réalisées. Le matériau getter est par exemple du zirconium et/ou du titane déposé sur une épaisseur comprise entre environ 100 nm et 2 µm. Les éventuelles sous-couches d'accroche et d'ajustement sont réalisées préalablement à la réalisation des portions de matériau getter 112. Il est également possible de déposer une sous-couche d'ajustement épaisse, c'est-à-dire d'épaisseur supérieure à environ 100 nm, de façon à augmenter l'aspect ratio, ou facteur de forme, de la tranchée et ainsi favoriser la fermeture de la tranchée par le dépôt du getter. Un tel cas peut s'appliquer à la configuration précédemment décrite en liaison avec la figure 5, avec dans ce cas la mise en oeuvre de deux dépôts : l'un pour la sous-couche d'ajustement et l'autre pour le matériau getter.

Ces portions de matériau getter 112 peuvent être réalisées par lift-off, c'est-à-dire par dépôt à travers un masque de résine préalablement réalisé par photolithographie et gravure sur la face 115 du premier substrat 102 et/ou la face 113 du deuxième substrat 104. Pour réaliser le masque en résine, un film sec de résine photosensible d'épaisseur comprise entre environ 1 et 10 µm est avantageusement utilisé, cette épaisseur pouvant même être inférieure à environ 1 µm afin d'obtenir la meilleure résolution possible pour la photolithographie mise en oeuvre. Lorsque la largeur des tranchées 116 est faible et proche d'environ 1 µm, une résine standard peut être utilisée pour réaliser le masque. Après le dépôt du matériau getter, le masque de résine ainsi que le matériau getter se trouvant sur le masque de résine sont retirés.

En variante, les portions de matériau getter 112 peuvent être réalisées par un dépôt du matériau getter sur l'ensemble de la face 115 du premier substrat 102 et/ou de la face 113 du deuxième substrat 104, puis des étapes de photolithographie et gravure du matériau getter déposé pour former les portions 112. Selon la nature du matériau getter, la gravure peut être réalisée par voir humide, ou par voie sèche telle qu'une gravure RIE (gravure ionique réactive).

Lorsque les portions de matériau getter 112 sont destinées à être recouvertes d'une couche de passivation telle que la couche 128 précédemment décrite, cette couche de passivation 128 est formée par exemple via un dépôt par évaporation de SiO₂, ce dépôt pouvant être réalisé dans le même bâti que celui ayant servi au dépôt des portions de matériau getter 112. Il est ainsi possible de créer une réserve de vide car le dépôt par évaporation peut être réalisé à une pression de l'ordre de 10⁻⁶ mbar. A contrario, un dépôt d'oxyde par pulvérisation cathodique sous une pression partielle d'un gaz porteur comme l'argon ou le krypton permet de créer une réserve de gaz.

Lorsqu'une ouverture 130 a été réalisée, on peut réaliser ensuite le dépôt localisé du matériau de bouchage 132 à proximité de l'ouverture 130. Lorsque le matériau de bouchage 132 comporte de l'or, ce dépôt correspond par exemple à un dépôt PVD (dépôt physique en phase vapeur) réalisé sur la face du substrat. Lorsque le matériau de bouchage 132 comporte de l'indium ou de l'étain, ce dépôt correspond par exemple à un dépôt PVD réalisé en partie sur la face du substrat et sur le matériau getter ou sur la sous-couche d'ajustement ou sur la sous-couche d'accroche. En variante, l'ouverture 130 peut être directement bouchée par le matériau de bouchage 134.

Le micro-dispositif 110 peut être réalisé sur le premier substrat 102 avant ou après la mise en oeuvre des différentes étapes ci-dessus. Lorsque les portions de matériau getter 112 sont destinées à être disposées à côté du micro-dispositif 110, les portions de matériau getter 112 sont de préférence réalisées avant la réalisation du micro-dispositif 110 et protégées notamment en ne faisant pas communiquer l'intérieur des tranchées 116 avec l'atmosphère ambiante, par exemple en bouchant au préalable une ouverture avec un matériau de bouchage comme précédemment décrit en liaison avec la figure 16, et éventuellement en protégeant les surfaces 118 des portions de matériau getter 112 par une couche de protection comme décrit précédemment.

Bien que le procédé d'encapsulation précédemment décrit soit réalisé pour l'encapsulation d'un seul micro-dispositif 110, ce procédé est avantageusement mis en oeuvre pour réaliser une encapsulation collective de plusieurs micro-dispositifs dans différentes cavités disposées les unes à côté des autres sur un même substrat.

## Revendications

1. Structure d'encapsulation (100) comportant au moins :
- une cavité (108) fermée hermétiquement dans laquelle un micro-dispositif (110) est encapsulé,
- un substrat (102, 104) dont une face (113, 115) délimite un côté de la cavité (108),
- au moins deux tranchées (116) formées à travers ladite face (113, 115) du substrat (102, 104), des volumes intérieurs de chacune des tranchées (116) communiquant entre eux,
- des premières portions de matériau getter (112) recouvrant au moins en partie des parois latérales des tranchées (116) sans remplir entièrement les tranchées (116),
- une ouverture (130) réalisée à travers l'une des premières portions de matériau getter (112) ou à travers le substrat (102, 104) et faisant communiquer les volumes intérieurs des tranchées (116) avec un volume intérieur de la cavité (108),
dans laquelle, lorsque l'ouverture (130) est réalisée à travers le substrat (102, 104) et communique avec les tranchées (116), les premières portions de matériau getter recouvrent complètement les tranchées (116) au niveau de ladite face (113, 115) du substrat (102, 104) ou, lorsque l'ouverture (130) est réalisée à travers l'une des premières portions de matériau getter (112), les premières portions de matériau getter recouvrent complètement les tranchées (116) au niveau de ladite face (113, 115) du substrat (102, 104) sauf au niveau de ladite ouverture (130).

2. Structure d'encapsulation (100) selon la revendication 1, dans laquelle les tranchées (116) sont réalisées dans le substrat (102, 104) selon un motif de grille tel que chacune des tranchées (116) croise au moins une autre tranchée (116).

3. Structure d'encapsulation (100) selon l'une des revendications précédentes, comportant en outre une ou plusieurs deuxièmes portions de matériau getter (124) disposées au niveau d'une ou plusieurs parois de fond des tranchées (116).

4. Structure d'encapsulation (100) selon l'une des revendications précédentes, dans laquelle l'ouverture (130) est bouchée par un matériau de bouchage (132, 134).

5. Structure d'encapsulation (100) selon l'une des revendications précédentes, dans laquelle les premières portions de matériau getter (112) recouvrent des parties de ladite face (113, 115) du substrat (102, 104) se trouvant autour des tranchées (116).

6. Structure d'encapsulation (100) selon l'une des revendications précédentes, dans laquelle les premières portions de matériau getter (112) comportent des grains colonnaires orientés selon une direction formant un angle non nul et inférieur à 90° avec les parois latérales des tranchées (116).

7. Structure d'encapsulation (100) selon l'une des revendications précédentes, dans laquelle des dimensions d'au moins une des tranchées (116), au niveau de ladite face (113, 115) du substrat (102, 104), sont inférieures à des dimensions de ladite au moins une des tranchées (116) au niveau d'une paroi de fond de ladite au moins une des tranchées (116).

8. Structure d'encapsulation (100) selon l'une des revendications précédentes, dans laquelle au moins une partie d'au moins une des tranchées (116) comporte plusieurs tranchées secondaires (116.1 - 116.3) formées à travers ladite face (113, 115) du substrat (102, 104), disposées les unes à côté des autres et dont les volumes intérieurs communiquent entre eux, les premières portions de matériau getter (112) recouvrant au moins en partie des parois latérales des tranchées secondaires (116.1 - 116.3).

9. Structure d'encapsulation (100) selon l'une des revendications précédentes, dans laquelle les premières portions de matériau getter (112) sont formées par au moins une première couche (112.1) d'un premier matériau getter et au moins une deuxième couche (112.2) d'un deuxième matériau getter.

10. Structure d'encapsulation (100) selon la revendication 9, dans laquelle le deuxième matériau getter est différent du premier matériau getter.

11. Structure d'encapsulation (100) selon l'une des revendications 9 ou 10, dans laquelle la première couche (112.1) du premier matériau getter recouvre complètement les tranchées (116) au niveau de ladite face (113, 115) du substrat (102, 104), et dans laquelle la deuxième couche (112.2) du deuxième matériau getter recouvre la première couche (112.1) du premier matériau getter.

12. Structure d'encapsulation (100) selon l'une des revendications 9 ou 10, dans laquelle la première couche (112.1) du premier matériau getter recouvre partiellement les tranchées (116) au niveau de ladite face (113, 115) du substrat (102, 104), et dans laquelle la deuxième couche (112.2) du deuxième matériau getter recouvre la première couche (112.1) du premier matériau getter et ferme complètement les tranchées (116) au niveau de ladite face (113, 115) du substrat (102, 104).

13. Procédé d'encapsulation d'au moins un micro-dispositif (110), comportant au moins la mise en oeuvre des étapes de :
- réalisation d'au moins deux tranchées (116) à travers une face (113, 115) d'un substrat (102, 104) telles que des volumes intérieurs de chacune des tranchées (116) communiquent entre eux;
- réalisation de premières portions de matériau getter (112) recouvrant au moins en partie des parois latérales des tranchées (116) sans remplir entièrement les tranchées (116), et recouvrant complètement les tranchées (116) au niveau de ladite face (113, 115) du substrat (102, 104) ;
- réalisation d'au moins une ouverture (130) à travers l'une des premières portions de matériau getter (112) ou à travers le substrat (102, 104) et faisant communiquer les volumes intérieurs des tranchées (116) avec un volume intérieur d'une cavité (108) dans laquelle le micro-dispositif (110) est disposé et telle que ladite face (113, 115) du substrat (102, 104) délimite un côté de la cavité (108) ;
- fermeture hermétique de la cavité (108).

## Patentansprüche

1. Einkapselungsstruktur (100), umfassend wenigstens:
- einen hermetisch geschlossenen Hohlraum (108), in dem eine Mikrovorrichtung (110) eingekapselt ist,
- ein Substrat (102, 104), dessen eine Fläche (113, 115) eine Seite des Hohlraums (108) begrenzt,
- wenigstens zwei Gräben (116), die durch die Fläche (113, 115) des Substrats (102, 104) hindurch gebildet sind, wobei Innenvolumina jedes der Gräben (116) miteinander verbunden sind,
- erste Bereiche aus Gettermaterial (112), die wenigstens teilweise Seitenwände der Gräben (116) bedecken, ohne die Gräben (116) vollständig auszufüllen,
- eine Öffnung (130), die durch einen der ersten Bereiche aus Gettermaterial (112) hindurch oder durch das Substrat (102, 104) hindurch realisiert ist und die Innenvolumina der Gräben (116) in Verbindung bringt mit einem Innenvolumen des Hohlraums (108),
wobei dann, wenn die Öffnung (130) durch das Substrat (102, 104) hindurch realisiert ist und in Verbindung mit den Gräben (116) ist, die ersten Bereiche aus Gettermaterial die Gräben (116) im Bereich der Fläche (113, 115) des Substrats (102, 104) vollständig bedecken, oder dann, wenn die Öffnung (130) durch einen der ersten Bereiche aus Gettermaterial (112) hindurch realisiert ist, die ersten Bereiche aus Gettermaterial die Gräben (116) im Bereich der Fläche (113, 115) des Substrats (102, 104) vollständig bedecken, außer im Bereich der Öffnung (130).

2. Einkapselungsstruktur (100) nach Anspruch 1, bei der die Gräben (116) in dem Substrat (102, 104) gemäß einem Gittermuster derart realisiert sind, dass jeder der Gräben (116) wenigstens einen anderen Graben (116) kreuzt.

3. Einkapselungsstruktur (100) nach einem der vorhergehenden Ansprüche, ferner umfassend einen oder mehrere zweite Bereiche aus Gettermaterial (124), die im Bereich einer oder mehrerer Bodenwände der Gräben (116) angeordnet sind.

4. Einkapselungsstruktur (100) nach einem der vorhergehenden Ansprüche, bei der die Öffnung (130) durch ein Verschlussmaterial (132, 134) verschlossen ist.

5. Einkapselungsstruktur (100) nach einem der vorhergehenden Ansprüche, bei der die ersten Bereiche aus Gettermaterial (112) Teile der Fläche (113, 115) des Substrats (102, 104) bedecken, die sich um die Gräben (116) herum befinden.

6. Einkapselungsstruktur (100) nach einem der vorhergehenden Ansprüche, bei der die ersten Bereiche aus Gettermaterial (112) säulenförmige Körner umfassen, die in einer Richtung orientiert sind, welche einen Winkel ungleich Null und kleiner als 90° mit den Seitenwänden der Gräben (116) bildet.

7. Einkapselungsstruktur (100) nach einem der vorhergehenden Ansprüche, bei der Abmessungen wenigstens eines der Gräben (116) im Bereich der Fläche (113, 115) des Substrats (102, 104) kleiner sind als Abmessungen des wenigstens einen Grabens (116) im Bereich einer Bodenwand des wenigstens einen Grabens (116).

8. Einkapselungsstruktur (100) nach einem der vorhergehenden Ansprüche, bei der wenigstens ein Teil wenigstens eines der Gräben (116) mehrere Sekundärgräben (116.1 - 116.3) umfasst, die durch die Fläche (113, 115) des Substrats (102, 104) hindurch gebildet sind, die nebeneinander angeordnet sind und deren Innenvolumina miteinander in Verbindung sind, wobei die ersten Bereiche aus Gettermaterial (112) wenigstens teilweise Seitenwände der Sekundärgräben (116.1 - 116.3) bedecken.

9. Einkapselungsstruktur (100) nach einem der vorhergehenden Ansprüche, bei der die ersten Bereiche aus Gettermaterial (112) durch wenigstens eine erste Schicht (112.1) aus einem ersten Gettermaterial und wenigstens eine zweite Schicht (112.2) aus einem zweiten Gettermaterial gebildet sind.

10. Einkapselungsstruktur (100) nach Anspruch 9, bei der das zweite Gettermaterial von dem ersten Gettermaterial verschieden ist.

11. Einkapselungsstruktur (100) nach einem der Ansprüche 9 oder 10, bei der die erste Schicht (112.1) des ersten Gettermaterials die Gräben (116) im Bereich der Fläche (113, 115) des Substrats (102, 104) vollständig bedeckt, und bei der die zweite Schicht (112.2) des zweiten Gettermaterials die erste Schicht (112.1) des ersten Gettermaterials bedeckt.

12. Einkapselungsstruktur (100) nach einem der Ansprüche 9 oder 10, bei der die erste Schicht (112.1) des ersten Gettermaterials teilweise die Gräben (116) im Bereich der Fläche (113, 115) des Substrats (102, 104) bedeckt, und bei der die zweite Schicht (112.2) des zweiten Gettermaterials die erste Schicht (112.1) des ersten Gettermaterials bedeckt und die Gräben (116) im Bereich der Fläche (113, 115) des Substrats (102, 104) vollständig schließt.

13. Verfahren zur Einkapselung wenigstens einer Mikrovorrichtung (110), umfassend wenigstens die Durchführung der folgenden Schritte:
- Realisieren von wenigstens zwei Gräben (116) durch eine Fläche (113, 115) eines Substrats (102, 104) hindurch derart, dass Innenvolumina jedes der Gräben (116) miteinander in Verbindung sind;
- Realisieren von ersten Bereichen aus Gettermaterial (112), die wenigstens teilweise Seitenwände der Gräben (116) bedecken, ohne die Gräben (116) vollständig auszufüllen, und die Gräben (116) im Bereich der Fläche (113, 115) des Substrats (102, 104) vollständig bedecken;
- Realisieren wenigstens einer Öffnung (130) durch einen der ersten Bereiche aus Gettermaterial (112) hindurch oder durch das Substrat (102, 104) hindurch, und Inverbindungsetzen der Innenvolumina der Gräben (116) mit einem Innenvolumen eines Hohlraums (108), in dem die Mikrovorrichtung (110) angeordnet ist, und derart, dass die Fläche (113, 115) des Substrats (102, 104) eine Seite des Hohlraums (108) begrenzt;
- hermetisches Schließen des Hohlraums (108).

## Claims

1. Encapsulation structure (100) comprising at least:
- a hermetically sealed cavity (108) in which a micro-device (110) is encapsulated,
- a substrate (102, 104) of which one face (113, 115) delimits one side of the cavity (108),
- at least two trenches (116) formed through said face (113, 115) of the substrate (102, 104), the interior volumes of each of the trenches (116) communicating together,
- first portions of getter material (112) covering at least in part side walls of the trenches (116) without entirely filling the trenches (116),
- an opening (130) formed through one of the first portions of getter material (112) or through the substrate (102, 104) and making the interior volumes of the trenches (116) communicate with an interior volume of the cavity (108),
in which, when the opening (130) is formed through the substrate (102, 104) and communicates with the trenches (116), the first portions of getter material completely cover the trenches (116) at said face (113, 115) of the substrate (102, 104) or, when the opening (130) is formed through one of the first portions of getter material (112), the first portions of getter material completely cover the trenches (116) at said face (113, 115) of the substrate (102, 104) except at said opening (130).

2. Encapsulation structure (100) according to claim 1, in which the trenches (116) are formed in the substrate (102, 104) according to a grid pattern such that each of the trenches (116) intersects at least one other trench (116).

3. Encapsulation structure (100) according to one of previous claims, further comprising one or more second portions of getter material (124) arranged at one or more bottom walls of the trenches (116).

4. Encapsulation structure (100) according to one of previous claims, in which the opening (130) is plugged with a plugging material (132, 134).

5. Encapsulation structure (100) according to one of previous claims, in which the first portions of getter material (112) cover parts of said face (113, 115) of the substrate (102, 104) located around the trenches (116).

6. Encapsulation structure (100) according to one of previous claims, in which the first portions of getter material (112) comprise columnar grains oriented along a direction forming a non-zero angle and less than 90° with the side walls of the trenches (116).

7. Encapsulation structure (100) according to one of previous claims, in which the dimensions of at least one of the trenches (116), at said face (113, 115) of the substrate (102, 104), are less than the dimensions of said at least one of the trenches (116) at a bottom wall of said at least one of the trenches (116).

8. Encapsulation structure (100) according to one of previous claims, in which at least one part of at least one of the trenches (116) comprises several secondary trenches (116.1 - 116.3) formed through said face (113, 115) of the substrate (102, 104), arranged next to each other and in which the interior volumes communicate together, the first portions of getter material (112) covering at least in part side walls of the secondary trenches (116.1-116.3).

9. Encapsulation structure (100) according to one of previous claims, in which the first portions of getter material (112) are formed by at least one first layer (112.1) of a first getter material and at least one second layer (112.2) of a second getter material.

10. Encapsulation structure (100) according to claim 9, in which the second getter material is different from the first getter material.

11. Encapsulation structure (100) according to one of claims 9 or 10, in which the first layer (112.1) of the first getter material completely covers the trenches (116) at said face (113, 115) of the substrate (102, 104), and in which the second layer (112.2) of the second getter material covers the first layer (112.1) of the first getter material.

12. Encapsulation structure (100) according to one of claims 9 or 10, in which the first layer (112.1) of the first getter material partially covers the trenches (116) at said face (113, 115) of the substrate (102, 104), and in which the second layer (112.2) of the second getter material covers the first layer (112.1) of the first getter material and completely seals the trenches (116) at said face (113, 115) of the substrate (102, 104).

13. Method of encapsulating at least one micro-device (110), comprising at least the implementation of the steps of:
- forming at least two trenches (116) through one face (113, 115) of a substrate (102, 104) such that the interior volumes of each of the trenches (116) communicate together;
- forming first portions of getter material (112) covering at least in part side walls of the trenches (116) without entirely filling the trenches (116), and completely covering the trenches (116) at said face (113, 115) of the substrate (102, 104);
- forming at least one opening (130) through one of the first portions of getter material (112) or through the substrate (102, 104) and making the interior volumes of the trenches (116) communicate with an interior volume of a cavity (108) in which the micro-device (110) is arranged and such that said face (113, 115) of the substrate (102, 104) delimits one side of the cavity (108);
- hermetic sealing of the cavity (108).
